# EUROPÄISCHE PATENTSCHRIFT

(11) **EP 0 696 410 B1**
(45) Veröffentlichungstag und Bekanntmachung des Hinweises auf die Patenterteilung: **16.07.1997**
(21) Anmeldenummer: 94915137.7
(22) Anmeldetag: 28.04.1994
(51) Int. Cl.: H05K 3/42, C25D 5/56

(54) **VERFAHREN ZUR DURCHKONTAKTIERUNG VON LEITERPLATTEN MITTELS LEITFÄHIGER KUNSTSTOFFE ZUR DIREKTEN METALLISIERUNG**
PROCESS FOR THROUGHPLATING PRINTED CIRCUIT BOARDS USING CONDUCTIVE PLASTICS FOR DIRECT PLATING
PROCEDE PERMETTANT DE REALISER UNE CONNEXION TRANSVERSALE ENTRE DES CARTES DE CIRCUITS AU MOYEN DE MATIERES PLASTIQUES CONDUCTRICES EN VUE D'UNE METALLISATION DIRECTE

(30) Priorität: 30.04.1993 DE 4314259
(43) Veröffentlichungstag der Anmeldung: 14.02.1996
(73) Patentinhaber: GRUNDIG Aktiengesellschaft, 90762 Fürth (DE)
(72) Erfinder: RÖSCH, Gerhard, D-90461 Nürnberg (DE); STUCKMANN, Walter, D-90518 Altdorf (DE)
(86) Internationale Anmeldenummer: EP9401340
(87) Internationale Veröffentlichungsnummer: WO9426082

(56) Entgegenhaltungen:
- EP-A- 0 348 795
- WO-A-89/08375
- FR-A- 2 649 126

## Beschreibung

Die Erfindung betrifft ein Verfahren zur Durchkontaktierung von Leiterplatten mittels leitfähiger Kunststoffe zur direkten Metallisierung, bei dem eine Polymerschicht mit intrinsisch elektrischer Leitfähigkeit festhaftend auf nichtleitende Stellen der Leiterplatten aufgebracht wird, auf welche eine Metallschicht aufgetragen wird.

Durchkontaktierte Leiterplatten werden bisher im wesentlichen durch chemische Metallabscheidung auf katalytisch aktivierte Oberflächen eines Trägermaterials hergestellt. Die außenstromlos niedergeschlagenen Metallschichten werden gegebenenfalls durch galvanische Metallabscheidung verstärkt. Diese Technologie erlaubt die Fertigung qualitativ hochwertiger Leiterplatten. Die katalytische Aktivierung erfolgt im allgemeinen mittels edelmetallhaltiger, kolloidaler, ionogener oder nichtionogener Katalysatoren, insbesondere auf Basis von Palladium und Zinn. Es sind auch nicht-edelmetallhaltige Systeme auf Basis von Kupfer bekannt.

Als nachteilig ist bei der bekannten Technik anzusehen, daß bereits geringfügige Abweichungen von den vorgeschriebenen Prozeßparametern zu einer fehlerhaften Metallisierung führen. Darüberhinaus sind der hohe Preis der edelmetallhaltigen Katalysatorsysteme und die erhebliche Belastung der Abwässer durch Verwendung von Formaldehyd und Komplexbildnern weitere Nachteile dieser bekannten und weitverbreiteten Technologie.

Um diese Nachteile zu vermeiden wurde eine neue Technologie entwickelt, die auf der Verwendung elektrisch leitfähiger Polymere beruht. Die neue Technologie bietet außerdem den Vorteil, daß bei hoher Qualität der Metallisierung eine Verringerung der Prozeßschritte erreicht werden konnte.

Die gebohrten, metallkaschierten Leiterplatten aus glasfaserverstärktem Epoxidharz durchlaufen folgende Arbeitsgänge:
1. mechanische Reinigung
2. Spülen
3. Anätzen
4. Spülen
5. Konditionieren
6. Spülen
7. oxidative Vorbehandlung
8. Spülen
9. Katalysieren
10. Aktivieren
11. Spülen
12. übliche Weiterbehandlung

Die mechanische Reinigung kann beispielsweise Entgraten durch Bürsten, Ultraschallreinigung usw. umfassen. Zur weiteren Reinigung werden die Leiterplatten angeätzt. Daran schließt sich das Konditionieren an, wodurch eine bessere Benetzbarkeit der Oberflächen erreicht wird. Bei der oxidativen Vorbehandlung wird in einer KMnO₄-Lösung bei hoher Temperatur (70 - 90°C) auf den nicht metallkaschierten Flächen der Leiterplatten, speziell den Bohrlochwandungen, eine Braunsteinschicht (MnO₂) durch Oxidation der Epoxidharzkomponenten abgeschieden. Beim Katalysieren werden die Leiterplatten vollständig mit einer wässerigen Lösung benetzt, die Monomere enthält (heterocyclische organische Verbindungen, meist Pyrrol). Im Anschluß an die Katalyse werden die Leiterplatten zur Bildung einer leitfähigen Polypyrrolschicht einer Aktivierung unterzogen. Dazu werden die Leiterplatten in eine sauere, wässerige Lösung getaucht. Durch eine säurekatalysierte, oxidative Polymerisationsreaktion wird die leitfähige Polymerschicht selektiv dort aufgebaut, wo bei der oxidativen Vorbehandlung Braunstein abgeschieden wurde, wobei der Braunstein als Oxidationsmittel dient. Daran anschließend erfolgt in bekannter Weise der Aufbau der Leiterbahnstrukturen beispielsweise mittels galvanischer Verkupferung. Zwischen allen Arbeitsschritten werden die Leiterplatten gespült, lediglich nach dem Katalysieren unterbleibt das Spülen.

Die oben kurz geschilderte Vorgehensweise zur Durchkontaktierung von Leiterplatten ist bekannt und wird beispielsweise in den Patentdokumenten DE 38 06 884 C1, DE 39 28 832 A1 und EP 0 417 750 A2 genau beschrieben. Weitere Angaben sind aus der Zeitschrift Blasberg-Mitteilungen, Nr. 11, November 1991, "DMS2, der Durchbruch", ersichtlich.

Bei der neuen Technologie zur Durchkontaktierung von Leiterplatten kommt es aber zu Problemen bei der Durchkontaktierung, wenn die Bildung der Braunsteinschicht auf den nichtleitenden Stellen der Leiterplatten gestört ist. Sowohl die Abscheidung von zu viel als auch von zu wenig Braunstein beeinflußt die Entstehung der leitfähigen Polymerschicht negativ. Besondere Schwierigkeiten bei der Bildung der Braunsteinschicht ergeben sich außerdem, wenn statt hochwertiger - und teurer - Leiterplattenbasismaterialien wie glasfaserverstärkter Epoxidharze (FR4) billigere Basismaterialien wie Phenolharz-Hartpapier (FR2), Epoxidharz-Papier (FR3) oder Epoxidharz-Papier mit glasfaserverstärkten Außenlagen (CEM) verwendet werden. Die Probleme bei Verwendung dieser Materialien resultieren aus der oxidativen Vorbehandlung der Leiterplatten, bei der die Papierinnenlagen und Acryl-Haftvermittler der billigeren Basismaterialien angegriffen werden, wodurch die Belegung mit der für die Polymerisation wichtigen Braunsteinschicht wesentlich verschlechtert wird und bei der galvanischen Metallisierung Fehlstellen auftreten.

Darüberhinaus ist es beispielsweise aus der Patentanmeldung EP 0 348 795 A2 bekannt, Verbundmaterialien aus einem Trägermaterial und einem elektrisch leitfähigen Polymerfilm herzustellen. Dazu wird das Trägermaterial zuerst mit einer Monomerlösung und anschließend mit einer wässerigen Lösung eines Oxidationsmittels, oder umgekehrt, in Kontakt gebracht.

Bei diesem bekannten Verfahren ergibt sich allerdings ein auf der gesamten Oberfläche des Trägermaterials fest anhaftender Polymerfilm. Die selektive Aufbringung einer Polymerschicht nur auf die nichtleitenden Flächen eines aus leitenden und nichtleitenden Materialien bestehenden Trägermaterials ist nach dem bekannten Verfahren nicht möglich. Ebensowenig wird die spezielle Problematik von Durchkontaktierungslöchern bei Leiterplatten behandelt.

Des weiteren kann, wie aus FR 2 649 126 A1 bekannt, während der Einwirkung des Oxidationsmittels die das Oxidationsmittel enthaltende wässrige Lösung gerührt werden, so daß die wässrige Lösung eine Strömung gegenüber dem Trägermaterial aufweist.

Aufgabe der vorliegenden Erfindung ist es deshalb, die bekannten Verfahren zur Durchkontaktierung von Leiterplatten mittels leitfähiger Kunststoffe, zur direkten Metallisierung derart weiterzuentwickeln, daß die Probleme, die sich aus der oxidativen Vorbehandlung ergeben, beseitigt werden. Gleichzeitig soll dabei weiterhin die selektive Aufbringung der leitfähigen Polymerschicht nur auf nichtleitende Flächen, speziell die Flächen der Durchkontaktierungslöcher, gewährleistet sein.

Erfindungsgemäß wird diese Aufgabe durch ein Verfahren mit den Merkmalen des Anspruches 1 gelöst. Die Polymerschicht wird dabei direkt auf das Basismaterial der Leiterplatten aufgebracht. Dies ist unter Auslassung der oxidativen Vorbehandlung möglich, weil insondere in den Durchkontaktierungslöchern aufgrund der Rauhigkeit, die durch das Bohren entstanden ist, eine hohe Adsorptionsfähigkeit vorhanden ist. Diese Adsorptionsfähigkeit gestattet eine gute Aufnahme der das Monomer enthaltenden Lösung. Mittels einer saueren, wässerigen Lösung, die in Bezug auf die Leiterplatten eine Strömung aufweist, wird die säurekatalysierte, oxidative Polymerisationsreaktion gestartet. Die sauere Lösung enthält zu diesem Zweck zusätzlich ein Oxidationsmittel.

In den rauhen Durchkontaktierungslöchern bildet sich eine festhaftende Polymerschicht. Die auf den glatten, metallkaschierten Oberflächen der Leiterplatten entstehende Polymerschicht haftet wegen der Strömungsgeschwindigkeit der Katalyselösung nicht fest an und kann deshalb leichter rückstandsfrei entfernt werden.

Der Vorteil des erfindungsgemäßen Verfahrens liegt insbesondere darin, daß gegenüber den bekannten Verfahren die bisher für eine selektive Polymerschichtbildung nur auf nichtleitenden Flächen als unerläßlich erachtete oxidative Vorbehandlung entfallen kann. Dies ermöglicht die Verwendung billigerer Basismaterialien für die Leiterplatten. Neben der daraus resultierenden Kostenersparnis ergibt sich eine weitere Umweltentlastung, da der Verfahrensschritt zur Braunsteinbildung entfallen kann.

Der Vorteil des Verfahrens nach Anspruch 2 ist die mittels horizontaler Prozeßtechnik schnell und sicher durchzuführende Durchkontaktierung.

Das Verfahren nach Anspruch 3 weist den Vorteil auf, daß durch die Verwendung der gleichen Lösung sowohl zum Aktivieren der Polymerisation als auch zum Entfernen der auf den leitenden Flächen entstehenden Polymere zwei Verfahrensschritte vereinigt werden können.

Bei der Herstellung der Durchkontaktierungslöcher ist neben dem Bohren auch das Stanzen möglich, da auch sehr rauhe und zerrissene Wandungen der Durchkontaktierungslöcher sicher und vollständig mit einer Polymerschicht überzogen werden. Dadurch ist eine große Kosteneinsparung möglich, da bei großen Leiterplattenstückzahlen das Stanzen der Durchkontaktierungslöcher wesentlich kostengünstiger durchzuführen ist als das Bohren.

Weitere vorteilhafte Ausgestaltungen des erfindungsgemäßen Verfahrens ergeben sich aus den übrigen Unteransprüchen. Insbesondere weist das Verfahren nach Anspruch 10 den Vorteil auf, daß sowohl Leiterplatten aus dem Basismaterial FR4 als auch Leiterplatten aus den billigeren Materialien FR2, FR3 und CEM sicher durchkontaktiert werden können.

Im folgenden werden die Verfahrensschritte des erfindungsgemäßen Verfahrens näher erläutert. Es wird dabei davon ausgegangen, daß das Verfahren in horizontaler Prozeßtechnik durchgeführt wird, da besonders im horizontalen Durchlaufverfahren kurze und wohl definierte Behandlungszeiten erreicht werden können, wie sie für die Erzeugung einer leitfähigen Polymerschicht notwendig sind.

Die mit den Durchkontaktierungslöchern versehenen, metallkaschierten Leiterplatten durchlaufen folgende Verfahrensschritte:
1. mechanische Reinigung
2. Spülen
3. Anätzen
4. Spülen
5. Konditionieren
6. Spülen
7. Katalysieren
8. Aktivieren
9. Spülen
10. übliche Weiterbehandlung

Die Verfahrensschritte 1. bis 6. entsprechen den oben beschriebenen ersten sechs Arbeitsgängen für das bekannte Verfahren und sind ausführlich in den genannten Dokumenten beschrieben.

Die Rauhigkeit der Lochwandungen verleiht den nichtleitenden Stellen eine gute Adsorptionsfähigkeit, wodurch die Adsorption einer für eine geschlossene Polymerschicht ausreichenden Menge einer Monomerlösung möglich ist. Aus diesem Grund können beim erfindungsgemäßen Verfahren die Durchkontaktierungslöcher sowohl gebohrt als auch gestanzt werden, da auch sehr rauhe und zerrissene Lochwandungen sicher mit einer Polymerschicht überzogen werden. Die Adsorptionsfähigkeit wird durch die Verwendung papierhaltiger Basismaterialien (FR2, FR3 oder CEM) noch gesteigert.

Zum Katalysieren nach Verfahrensschritt 7. wird eine wässerige Monomerlösung verwendet, die heterocyclische organische Verbindungen, beispielsweise Pyrrol, enthält. Die Lösung enthält neben Pyrrol (1 - 20 Vol%) ein organisches Lösungsmittel (50 - 99 Vol%). Der verbleibende Rest ist Wasser. Der pH-Wert der Lösung liegt vorzugsweise zwischen 7 und 12. Besonders gute Ergebnisse ergeben sich, wenn in der Lösung ein Anteil von 8 - 12 Vol% Pyrrol enthalten ist. Die Behandlungsdauer beträgt 0,2 - 20 Minuten, die Temperatur vorzugsweise 15 - 20°C.

Die Leiterplatten werden mit der beschriebenen Lösung vollständig durch Tauchen oder Fluten mittels einer stehenden Welle benetzt.

Im darauffolgenden Verfahrensschritt 8. erfolgt die Aktivierung zur Bildung der Polypyrrolleitschicht. Mittels einer saueren, wässerigen Lösung, die zusätzlich ein Oxidationsmittel enthält, wird eine säurekatalysierte, oxidative Polymerisationsreaktion ausgelöst. Die Lösung enthält neben einem Anteil von 1 - 20 Gew% einer Säure, wie Salz-, Schwefel- oder Phosphorsäure usw., einen Anteil von 2 - 10 Gew% H₂O₂, bzw. 1 - 20 Gew% Alkalipersulfat (z.B. Natriumpersulfat), den Rest bildet Wasser. Die beim unten beschriebenen Aufbringen der Lösung vorhandene Strömungsgeschwindigkeit bewirkt, daß das sich bildende Polymer nur lose auf der glatten metallischen Oberfläche anhaftet, weshalb es in einem nachfolgenden Schritt leicht entfernt werden kann. Das feste Anhaften des Polymers auf den metallischen Oberflächen wird außerdem durch das Anätzen der Metallschicht durch den Säurebestandteil der Lösung sowie durch das in der Lösung enthaltene Alkalipersulfat verhindert. Das in den nichtleitenden Stellen der Leiterplatte adsorbierte Monomer bildet dagegen bei der Polymerisation eine an diesen Stellen festhaftende Polymerschicht. Die Behandlungszeit beträgt 10 Sekunden bis 2 Minuten, die Temperatur 20 - 50°C, wobei bei 30°C besonders gute Ergebnisse erzielt werden.

Bei der verwendeten horizontalen Prozeßtechnik wird die Aktivierungslösung am vorteilhaftesten durch Befluten mittels einer stehenden Welle aufgebracht. Nach der Beschwallung der Leiterplatten kann die lose auf den Leiterplattenoberflächen anhaftende Polymerschicht durch Besprühen entfernt werden. Besonders vorteilhaft ist die Verwendung der Aktivierungslösung, wodurch die definierte, vollständige Polymerisation der adsorbierten Monomere erreicht wird.

Die Entfernbarkeit der Polymerschicht von den metallischen Oberflächen wird noch verbessert, wenn die Leiterplatten vor dem Befluten mit der Aktivierungslösung besprüht werden.

Im Verfahrensschritte 9. werden die Reste der Polymerschicht von leitenden Stellen und die Aktivierungslösung durch Spülen mit H₂O entfernt.

Daran schließen sich die üblichen und bekannten Weiterbehandlungsschritte an, um die Durchkontaktierung zu verstärken, bzw. die gewünschten Leiterbahnen zu erzeugen. Dies kann galvanisch oder außenstromlos erfolgen.

Zur Metallisierung bzw. Metallkaschierung eignen sich die Metalle Kupfer, Nickel, Gold, Palladium, Zinn, Blei oder Zinn/Blei besonders.

Prinzipiell sind alle bekannten Verfahren wie Subtraktiv-, Semiadditiv- und Additivtechnik möglich. Diese Verfahren werden beispielsweise in den eingangs erwähnten Dokumenten näher beschrieben.

Wie umfangreiche Untersuchungen gezeigt haben, müssen, um optimale Ergebnisse zu erzielen, verschiedene Verfahrensschritte abgeändert werden. Ein Ansatzpunkt besteht darin, daß beispielsweise der Kupferelektrolyt zur galvanischen Metallisierung an die Besonderheiten der Polypyrrolschicht angepaßt werden muß, wenn die Metallisierung der Polypyrrolschicht erst nach dem Photoprozeß erfolgt. Übliche in der Leiterplattentechnik bisher allgemein verwendete Kupferelektrolyte führen dagegen zu einer fehlerhaften Metallabscheidung.

Werden statt der papierhaltigen Basismaterialien für die Leiterplatten (FR2, FR3, CEM) glasfaserverstärkte Basismaterialien wie FR4 verwendet, so hat es sich als vorteilhaft herausgestellt, die nichtleitenden Stellen der Leiterplatten - insbesondere die Durchkontaktierungslöcher - vor dem Verfahrensschritt Katalysieren anzuquellen. Dadurch wird die Adsorptionsfähigkeit dieser Basismaterialien verbessert, wodurch die Adsorption einer größeren Menge der Katalyselösung möglich ist. Besonders vorteilhaft für den weiteren Verfahrensablauf ist es, wenn zum Anquellen das organische Lösungsmittel verwendet wird, das auch in der Katalyselösung enthalten ist.

Neben der Durchkontaktierung beidseitig mit Leiterbahnen versehener Leiterplatten ist auch die Durchkontaktierung von Leiterplatten möglich, die zusätzlich im Inneren Leiterbahnen aufweisen (sog. Multilayer). Es zeigte sich, daß bei diesem Leiterplattentyp höhere Anforderungen an die Reinigung der Durchkontaktierungslöcher zu stellen sind. Insbesondere muß verhindert werden, daß die im Inneren gelegenen Leiterbahnen, die mittels der metallisierten Durchkontaktierungslöcher elektrisch leitend verbunden werden sollen, beim Bohren der Löcher vom Basismaterial verdeckt oder verschmiert werden.

## Patentansprüche

1. Verfahren zur Durchkontaktierung von Leiterplatten mittels leitfähiger Kunststoffe zur direkten Metallisierung, bei dem eine Polymerschicht mit intrinsisch elektrischer Leitfähigkeit festhaftend auf nichtleitende Stellen der Leiterplatten aufgebracht wird, auf welche eine Metallschicht aufgetragen wird,
die Leiterplatten beidseitig metallkaschiert und mit durch Bohren oder Stanzen erzeugten Durchkontaktierungslöchern versehen sind und die Polymerschicht direkt auf das Basismaterial der Leiterplatten aufgebracht wird, wobei
- in einem ersten Verfahrensschritt die gesamte Oberfläche der Leiterplatten sowie die Durchkontaktierungslöcher mit einer Lösung benetzt werden, die ein das Polymer bildende Monomer enthält, welches vor allem in den Wandungen der Durchkontaktierungslöcher adsorbiert wird,
- in einem zweiten Verfahrensschritt das Monomer unter Einwirkung einer saueren wässerigen, oxidierende Substanzen enthaltenden Lösung polymerisiert wird, wobei die Lösung eine Strömungsgeschwindigkeit gegenüber den Leiterplatten aufweist, und
- in einem dritten Verfahrensschritt die im zweiten Verfahrensschritt entstandenen, lose an der Metallkaschierung der Leiterplatten anhaftenden Polymere entfernt werden.

2. Verfahren nach Anspruch 1,
**gekennzeichnet durch**
die Verwendung horizontaler Prozeßtechnik.

3. Verfahren nach Anspruch 1 oder 2,
**dadurch gekennzeichnet**, daß
die Entfernung der Polymerschicht von den Metallkaschierungen der Leiterplatte im dritten Verfahrensschritt durch Besprühen oder Beschwallen mit der gleichen saueren wässerigen Lösung, wie sie im zweiten Verfahrensschritt verwendet wird, erfolgt.

4. Verfahren nach einem der Ansprüche 1 bis 3,
**dadurch gekennzeichnet**, daß
die Metallschicht aus einem der Metalle Kupfer, Nickel, Gold, Palladium, Zinn, Blei oder Zinn/Blei besteht.

5. Verfahren nach einem der Ansprüche 1 bis 4,
**dadurch gekennzeichnet**, daß
zur Durchführung des ersten Verfahrensschritts eine Lösung enthaltend ein Monomer, ein organisches Lösungsmittel und Wasser verwendet wird.

6. Verfahren nach Anspruch 5,
**dadurch gekennzeichnet**, daß
die Lösung zur Durchführung des ersten Verfahrensschritts 1 bis 20 Vol% Monomer sowie 50 bis 99 Vol% organisches Lösungsmittel oder Wasser oder 50 bis 99 Vol% eines Gemisches aus organischem Lösungsmittel und Wasser enthält.

7. Verfahren nach einem der Ansprüche 1 bis 6,
**dadurch gekennzeichnet**, daß
das verwendete Monomer Pyrrol ist.

8. Verfahren nach einem der Ansprüche 1 bis 7,
**dadurch gekennzeichnet**, daß
die Lösung zur Durchführung des zweiten Verfahrensschritts 1 bis 20 Gew% Schwefel- oder Salz- oder Phosphorsäure, 1 bis 20 Gew% Alkalipersulfate und/oder 2 - 10 Gew% H₂O₂, Rest Wasser, enthält.

9. Verfahren nach einem der Ansprüche 1 bis 8,
**dadurch gekennzeichnet**, daß
zur Durchführung des Verfahrens Leiterplatten verwendet werden, die aus einem papierhaltigem Basismaterial bestehen, und
daß bei Verwendung von glasfaserverstärktem Basismaterial die nichtleitenden Stellen vor dem ersten Verfahrensschritt mittels eines organischen Lösungsmittels angequollen werden, wobei insbesondere das in der Lösung nach dem ersten Verfahrensschritt verwendete organische Lösungsmittel zum Einsatz kommt.

## Claims

1. Process for the through-contacting of circuit boards by means of conductive plastics for direct metallization, in which an intrinsically electrically conductive polymer layer is applied adhesively to non-conducting locations of the circuit boards, to which a metal layer is applied, the circuit boards are metal-clad on both sides and provided with through-contacting holes produced by drilling or punching and the polymer layer is applied directly on to the base material of the circuit boards, whereby
- in a first process step, the entire surface of the circuit boards and the through-contacting holes are wetted with a solution which contains a monomer, forming the polymer, which is primarily adsorbed into the walls of the through-contacting holes,
- in a second process step, the monomer is polymerized by the action of an acid, aqueous solution containing oxidizing substances, the solution having a flow speed relative to the circuit boards, and
- in a third process step, the polymers produced in the second process step and adhering loosely to the metal cladding of the circuit boards are removed.

2. Process according to Claim 1, characterized by the use of a horizontal process technique.

3. Process according to Claim 1 or 2, characterized in that the removal of the polymer layer from the metal cladding of the circuit board in the third process step is effected by spraying or flooding with the same acid, aqueous solution used in the second process step.

4. Process according to one of Claims 1 to 3, characterized in that the metal layer consists of one of the metals copper, nickel, gold, palladium, tin, lead or tin/lead.

5. Process according to one of Claims 1 to 4, characterized in that a solution containing a monomer, an organic solvent and water is used for the execution of the first process step.

6. Process according to Claim 5, characterized in that the solution for the execution of the first process step contains 1 to 20 % by volume of monomer and 50 to 99 % by volume of organic solvent or water or 50 to 99 % by volume of a mixture of an organic solvent and water.

7. Process according to one of Claims 1 to 6, characterized in that the monomer used is pyrrole.

8. Process according to one of Claims 1 to 7, characterized in that the solution for the execution of the second process step contains 1 to 20 % by weight of sulphuric or hydrochloric or phosphoric acid, 1 to 20 % by weight of alkali persulphate and/or 2 - 10 % by weight of H₂O₂, the remainder being water.

9. Process according to one of Claims 1 to 8, characterized in that, for the execution of the process, circuit boards are used which consist of a base material containing paper, and in that, in the case of use of glass-fibre-reinforced base material, the non-conducting locations are swollen prior to the first process step by means of an organic solvent, whereby, in particular, the organic solvent used in the solution in the first process step is used.

## Revendications

1. Procédé pour former des contacts traversants dans des plaquettes à circuits imprimés à l'aide de matières plastiques conductrices pour l'établissement d'une métallisation directe, selon lequel on dépose une couche de polymère possédant une conductivité électrique intrinsèque de manière qu'elle adhère fermement en des emplacements non conducteurs des plaquettes à circuits imprimés, sur lesquels est déposée une couche métallique, on dépose un placage métallique sur les deux faces des plaquettes à circuits imprimés et on y forme des trous de contacts traversants produits par perçage ou poinçonnage et on dépose la couche de polymère directement sur le matériau de base des plaquettes à circuits imprimés, et selon lequel
- lors d'une première étape opératoire, on mouille l'ensemble de la surface des plaquettes à circuits imprimés ainsi que les trous de contacts traversants avec une solution qui contient un monomère formant le polymère et qui est absorbé surtout dans les parois des trous de contacts traversants,
- lors d'une seconde étape opératoire, on fait polymériser le monomère sous l'action d'une solution aqueuse acide contenant des substances oxydantes, la solution possédant une vitesse d'écoulement par rapport aux plaquettes à circuits imprimés, et
- lors d'une troisième étape opératoire, on élimine les polymères, qui sont apparus lors de la seconde étape opératoire et qui adhèrent de façon lâche au placage métallique des plaquettes à circuits imprimés.

2. Procédé selon la revendication 1, caractérisé par l'utilisation d'une technique de traitement horizontale.

3. Procédé selon la revendication 1 ou 2, caractérisé en ce que l'élimination de la couche de polymère à partir des placages métalliques de la plaquette à circuits imprimés s'effectue, lors de la troisième étape opératoire, par pulvérisation de la même solution aqueuse acide que celle utilisée lors de la seconde étape opératoire, ou l'application de cette solution par une onde stationnaire.

4. Procédé selon l'une des revendications 1 à 3, caractérisé en ce que la couche métallique est formée de l'un des métaux cuivre, nickel, or, palladium, étain, plomb ou étain / plomb.

5. Procédé selon l'une des revendications 1 à 4, caractérisé en ce que, pour la mise en oeuvre de la première étape opératoire, on utilise une solution contenant un monomère, un solvant organique et de l'eau.

6. Procédé selon la revendication 5, caractérisé en ce que la solution pour la mise en oeuvre de la première étape opératoire contient 1 à 20% en volume d'un monomère et 50 à 99% en volume d'un solvant organique ou d'eau ou 50 à 99% en volume d'un mélange d'un solvant organique et d'eau.

7. Procédé selon l'une des revendications 1 à 6, caractérisé en ce que le monomère utilisé est du pyrrol.

8. Procédé selon l'une des revendications 1 à 7, caractérisé en ce que la solution pour la mise en oeuvre de la seconde étape opératoire contient 1 à 20% en poids d'acide sulfurique ou d'acide chlorhydrique ou d'acide phosphorique, 1 à 20% en poids d'un persulfate d'alcali et/ou 2 - 10% en poids de H₂O₂, le reste étant formé d'eau.

9. Procédé selon l'une des revendications 1 à 8, caractérisé en ce que pour la mise en oeuvre du procédé, on utilise des plaquettes à circuits imprimés, qui sont constituées d'un matériau de base contenant du papier, et que dans le cas de l'utilisation d'un matériau de base renforcé par des fibres de verre on fait gonfler les emplacements non conducteurs avant la première étape opératoire, à l'aide d'un solvant organique, auquel cas on utilise notamment le solvant organique utilisé dans la solution employée dans la première étape opératoire.
